## Europäisches Patentamt

## European Patent Office

## Office européen des brevets

(19)

(11) Numéro de publication: **0 065 464**
**B1**

(12)
# FASCICULE DE BREVET EUROPEEN

(45) Date de publication du fascicule du brevet:
**23.01.85**

(51) Int. Cl.⁴: **H 01 L 21/76,** H 01 L 21/265,
H 01 L 21/82

(21) Numéro de dépôt: **82400877.5**

(22) Date de dépôt: **11.05.82**

(54) **Procédé de fabrication de circuits intégrés de type MOS.**

(30) Priorité: **12.05.81 FR 8109432**

(43) Date de publication de la demande:
**24.11.82 Bulletin 82/47**

(45) Mention de la délivrance du brevet:
**23.01.85 Bulletin 85/4**

(84) Etats contractants désignés:
**DE FR IT NL**

(73) Titulaire: **SOCIETE POUR L'ETUDE ET LA FABRICATION
DE CIRCUITS INTEGRES SPECIAUX - E.F.C.I.S.,**
**17, avenue des Martyrs, F-38100 Grenoble (FR)**

(72) Inventeur: **Brevignon, Jean-Pierre, THOMSON-CSF
SCPI 173, bld Haussmann, F-75379 Paris Cedex 08 (FR)**
Inventeur: **Dubois, Guy, THOMSON-CSF SCPI 173, bld
Haussmann, F-75379 Paris Cedex 08 (FR)**

(74) Mandataire: **de Beaumont, Michel et al, THOMSON-CSF
SCPI 173, Bld Haussmann, F-75379 Paris Cedex 08 (FR)**

(56) Documents cités:
**GB - A - 2 053 565**
**US - A - 4 140 547**

**IEEE TRANSACTIONS ON ELECTRON DEVICES, vol.
ED-29, no. 4, avril 1982, pages 541-547, New York (USA);**

## Description

La présente invention concerne un procédé de fabrication de circuits intégrés comprenant des transistors à effet de champ du type à métal-oxyde-semiconducteur (MOS) et concerne plus particulièrement la formation de zones d'oxyde de champ et de zones dopées sous-jacentes dans de tels circuits intégrés.

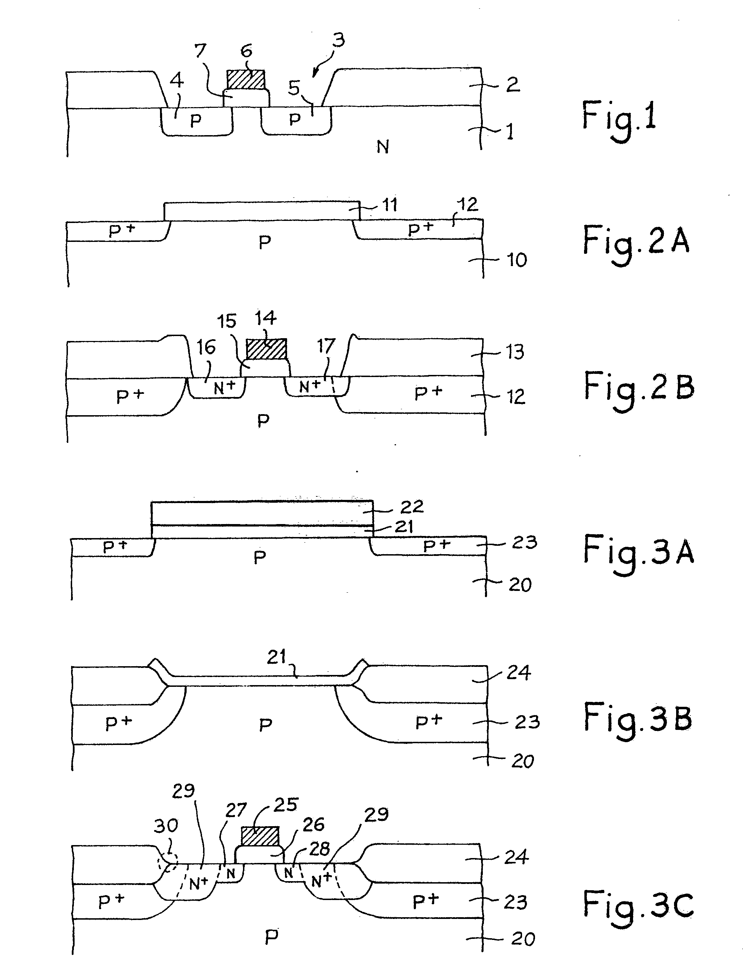

Dans les circuits intégrés de type MOS, il est généralement prévu à la surface de la couche semiconductrice qui peut être une couche superficielle dopée selon un type de conductivité particulier ou une plaquette semiconductrice de dopage choisi, des zones recouvertes d'une couche d'oxyde de silicium épaisse par rapport à l'épaisseur de la couche isolante comprise entre la grille et la coue de silicium. L'un des rôles de ces couches localisées d'oxyde épais est de séparer les composants individuels constituant le circuit intégré. Ces couches d'oxyde sont couramment appelées »oxyde de champ«. Dans le but d'assurer une certaine isolation entre composants distincts et d'eviter la création de canaux parasites sous l'effet des courants circulant dans des connexions formées sur ces zones d'oxyde de champ, celles-ci reposent habituellement sur des zones du substrat de silicium spécifiquement dopées. On va tout d'abord retracer cidessous en relation avec les figures 1 à 3 quelques étapes importantes des principaux procédés couramment utilisés pour former ces zones d'oxyde de champ.

Tout d'abord, dans les premiers circuits intégré MOS, on utilisait habituellement, comme le représente la figure 1, des transistors MOS à canal de type P élaborés sur du silicium de type N. Dans ce cas, le substrat de silicium 1 était recouvert, généralement par oxydation thermique, d'une couche 2 de silice épaisse (1,2 à 2 microns) dans laquelle étaient ouvertes des fenêtres 3 où étaient des transistors MOS élémentaires comprenant des zones de source 4 et de drain 5 de type P, séparées par une zone dans laquelle est susceptible de se former un canal de type P sous l'effet d'un potentiel appliqué à une grille 6 formée sur une couche d'oxyde de grille 7 mince (par exemple 0,12 micron). Dans le cas des transistors MOS à canal formés sur substrat N, les tensions appliquées sur des conducteurs disposés audessus des zones d'oxyde de champ 2 étaient peu susceptibles de former des zones d'inversion, c'est-à-dire des zones de canal parasite pouvant assurer la conduction entre des zones de drain et/ou de source de transistors MOS adjacents. Il n'était donc pas prévu de dopage de type particulier des zones du sustrat sousjacentes aux zones d'oxyde de champ 2. D'autre part, dans ces premières réalisations, les longueurs de canal étaient relativement importantes (de l'ordre de la dizaine de microns) et les largeurs d'oxyde de champ entre transistors adjacents étaient de l'ordre de la trentaine de microns.

Les figures 2A et 2B illustrent le cas des premières réalisations de transistors MOS à canal N. Le transistor était élaboré sur un substrat 10 de type P. Les zones dans lesquelles on souhaitait former les transistors élémentaires étaint recouvertes d'une couche de masquage 11 permettant une protection par rapport à des diffusions ou implantations de champ 12 de type $P^+$. Après quoi, une couche d'oxyde épaisse 13 était formée (épaisseur supérieure à un micron). Cette couche était ensuite ouverte aux emplacements correspondant sensiblement aux zones où était déposée la couche 11. On obtenait ainsi des zones d'oxyde de champ 13 recouvrant les zones 12 dans lesquelles le dopage de champ avait été effectué. Après quoi, on formait la grille conductrice 14 sur une couche isolante 15 et l'on formait par implantation et diffusion des zones surdopées de source et de drain 16 et 17.

La structure d'un transistor à canal N, telle que représentée en figure 2B, diffère de celle d'un transistor à canal P, tel que représenté en figure 1, par le fait qu'il est nécessaire, dans le cas du transistor à canal N, de prévoir une zone surdopée de champ 12 en-dessous des zones d'oxyde de champ pour éviter la création de canaux parasites.

Un inconvénient du procédé des figures 2A et 2B réside dans le fait qu'il nécessite l'utilisation de deux étapes de masquage successives pour découper d'abord la couche 11 et définir les zones implantées 12, puis ensuite pour masquer la couche d'oxyde de champ 13, ce deuxième masquage devant être fait avec autant de précision que possible en conformité avec le premier. Il en résulte que cette technique ne s'applique plus quand on cherche à diminuer les dimensions des transistors à effet de champ élémentaires.

Ainsi, à l'heure actuelle, pour éviter l'inconvénient cidessus on utilise couramment des procédés d'autoalignement, par exemple des procédés couramment déssignes par l'appelation »locos« tels qu'illustrés dans leurs principales étapes en relation avec les figures 3A à 3C.

Dans une première étape, illustrée en figure 3A, on dépose sur un substrat 20 de type P une couche de nitrure de silicium 21 découpée selon un profil approprié à l'aide d'un masque d'un produit photosensible 22 (une mince couche d'oxyde, non représentée, étant présente à l'interface nitrure/silicium). Ce masque et la couche 21 servent à délimiter une implantation de champ 23 de type P. Ensiute (figure 2B), après enlèvenent de la couche de produit photosensible 22, on procède à une oxydation thermique. Cette oxydation se produit sur les parties de silicium restées à nu, au-dessus des zones implantées, sans que les zones recouvertes de la coue de nitrure 21 soient affectées. On obtient ainsi une couche d'oxyde thermique 24 exactement localisée au-dessus des zones implantées tout en ayant utilisé un seul masque. De façon classique, comme illustré en figure 3C, après avoir enlevé la couche de nitrure de silicium 21, on forme alors une grille 25 au-dessus d'une zone d'oxyde de grille 26 et l'on procède aux implantations ou diffusions de source et de drain 27 et 28, puis éventuellement à des implantations ou diffusions de type N plus fortement dopées de reprise de contact de source et de drain 29.

Ce procédé de type »locos« présente l'avantage, comme cela a été exposé, de permettre un autoalignement des zones dopées de champ 23 et des zones d'oxyde de champ 24. Néanmoins, d'autres inconvénients, qui existaient déjà dans la structure illustrée en figure 2B, demeurent. Notamment, au cours de la croissance de la couche d'oxyde thermique de champ 24, il se produit une extension par diffusion de la zone impantée de champ 23. Cette diffusion a, d'une part, lieu dans le sens vertical de l'épaisseur de la plaquette semi-conductrice 20, mais aussi dans le sens latéral, ce que diminue les possibilités de miniaturisation des transistors à effet de champ élémentaires. Un autre inconvénient, propre à la structure de type »locos« est que, à la limite de la couche d'oxyde thermique 24 du côté du transistor à effet de champ, dans les régions désignées par la référence 30, se produit ce que est couramment appelé dans la littérature un »bec d'oiseau« (birds beak). Ceci correspond à une extension latérale de l'oxyde de champ par rapport au bord défini par la couche de nitrure. Il en résulte une zone fortement perturbée et il n'est pas possible, en général, de prendre des contacts très près de cette zone, ce que limite les possibilités de miniaturisation dimensionnelle.

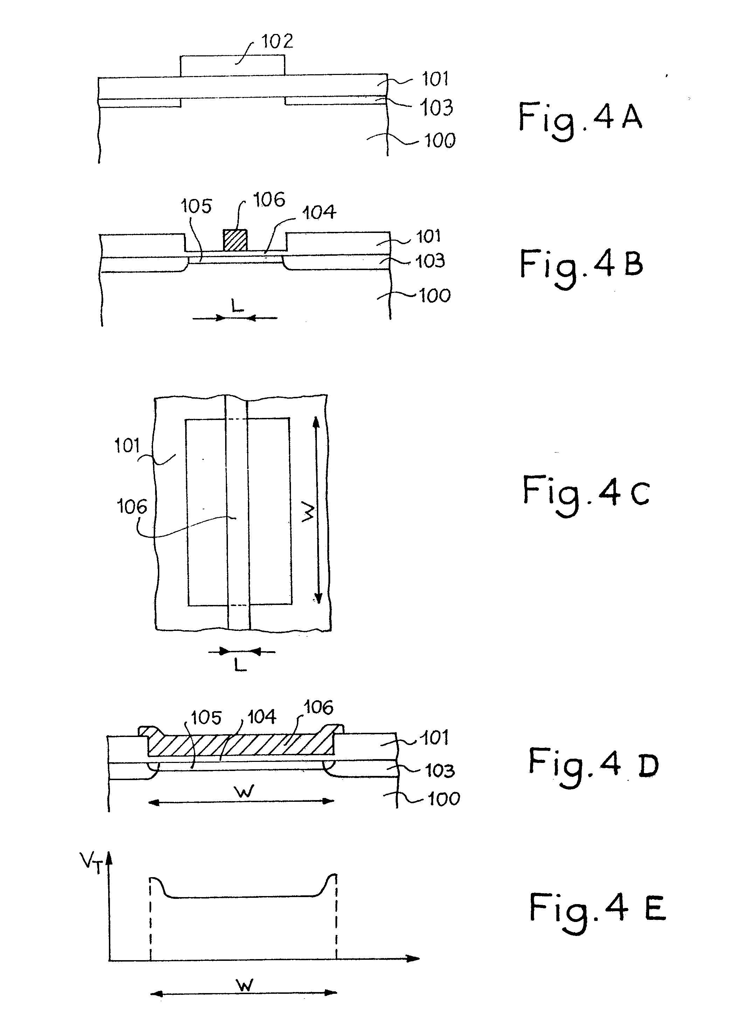

Le brevet américain 41 40 547 se donne pour objet de remédier à certains inconvénients du procédé locos. Comme le représentent les figures 4A et 4B, ce brevet propose de partir d'un substrat de silicium 100 sur lequel sont formées une ou plusieurs couches isolantes 101, les parties dans lesquelles on veut former des composants MOS (zones actives) étant protégées par des zones de résine 102. On procède alors à une implantation ionique à travers la couche isolante 101 pour former des zones implantées 103 dans le substrat de silicium 100, cette implantation étant masquée par les zones de résine 102. Le brevet enseigne divers moyens d'autoalignement pour attaquer sélectivement la couche 101 dans les zones actives sous les zones de résine 102. On arrive alors à une structure du type illustré en figure 4B dans laquelle il existe des zones d'isolement de champ 101 sous lesquelles existe une implantation de champ 103. La zone active est recouverte d'une zone d'oxyde de grille 104 à travers laquelle est réalisée une implantation de seuil 105 destinée à ajuster la tension de fonctionnement du transistor MOS dont la grille de longueur L est désignée par la référence 106.

Le procédé décrit dans ce brevet américain permet effectivement de pallier certrains inconvénients du procédé »locos« mais, d'une part, implique une étape d'autoalignement complexe à mettre en oeuvre et, d'autre part, présente encore de nombreux inconvénients dont certains vont être mis en relation avec les figures 4C à 4E.

La figure 4C représente une vue de dessus d'une zone active entourée par une zone d'isolant de champ 101. Cette zone est traversée par une grille 106 de longueur L et de largeur w (on notera que la lageur de la grille est généralement supérieur à sa longueur que correspond à la longueur du canal que l'on cherche à minimiser).

La figure 4D est une vue en coupe selon un plan perpendiculaire à celiu des figures 4A et 4B. La grille (métal ou silicium polycristallin) s'étend sur toute la largeur w de la zone active. La diffusion de l'implantation de champ 103 s'étend peu sous la zone active étant donné que cette implantation a été réalisée après l'oxydation de champ. Néanmoins cette extension est non négligeable et se produit notamment pendant la formation de l'oxyde de grille 104. Ainsi la concentration en atomes dopants dans le silicium sous les extrémités de la larbeur de la grille est différente de la concentration sous la partie centrale de la grille. Une conséquence en est, comme le montre la figure 4E, que la tension de seuil $V_T$ par unité de larbeur de grille n'est pas constante. La tension de seuil moyenne varierea donc pour deux transistors MOS de largeurs différentes que n'auront pas la même sensibilité.

Un objet de la présente invention est de prévoir un procédé de formation de zones d'oxyde de champ et d'implantation de champ qui évite les inconvénients des procédés antérieurs.

Un autre objet de l'invention est de prévoir un tel procédé qui permette une plus grande miniaturisation des transistors MOS en éliminant les inconvénients liés à la diffusion latérale d'implantations de champ localisées.

Un autre objet de la présente invention est de prévoir un tel procédé que soit plus simple à mettre en oeuvre que les procédés antérieurs d'où il résulte une économie de coût et de durée de fabrication.

Selon la présente invention, que s'applique plus particulièrement au cas où l'on cherche à faire des transistors de très faibles dimensions (longueur de canal de l'ordre de 1 à 2 microns) et dans lesquels la couche d'oxyde thermique de champ a une épaisseur de l'ordre de 0,2 à 0,6 micron, il est prévu de former d'arbord une couche d'oxyde thermique de champ uniforme, puis de procéder à une implantation ionique uniforme dans le silicium à travers toute la surface de cette couche d'oxyde de champ. Ensuite seulement l'oxyde de champ est enlevé au-dessus des zones actives que sont éventuellement soumises à des implantations de seuil localisées distinctes.

Du fait de la réalisation de l'implantation uniforme après l'oxydation de champ, l'extension verticale de la zone implantée reste faible, par exemple de l'ordre de 3000Å ce qui permet d'assurer une grande plage de tensions de fonctionnement du circuit intégré. D'autre part, étant donné que l'implantation de champ n'est pas localisée, on évite les difficultés liées aux diffusions latérales et la tension de seuil par unité de largeur de grille est uniforme. En outre, dans certains cas l'implantation de champ pourra être telle qu'il soit inutile de prévour des implantations de seuil dans certaines zones actives.

Ces objets, caractéristiques et avantages ainsi que d'autres de la présente invention seront exposés plus en détail dans la description suivante d'un mode de réalisation pariculier faite en relation avec les figures jointes parmi lesquelles:

les figures 1, 2A, 2B, 3A à 3C et 4A à 4E ont été décrites précédemment en relation avec l'exposé de l'état de la technique;

les figures 5A à 5G illustrent des étapes successives de fabrication d'une portion d'un circuit intégré, les premières étapes correspondant au procédé selon la présente invention.

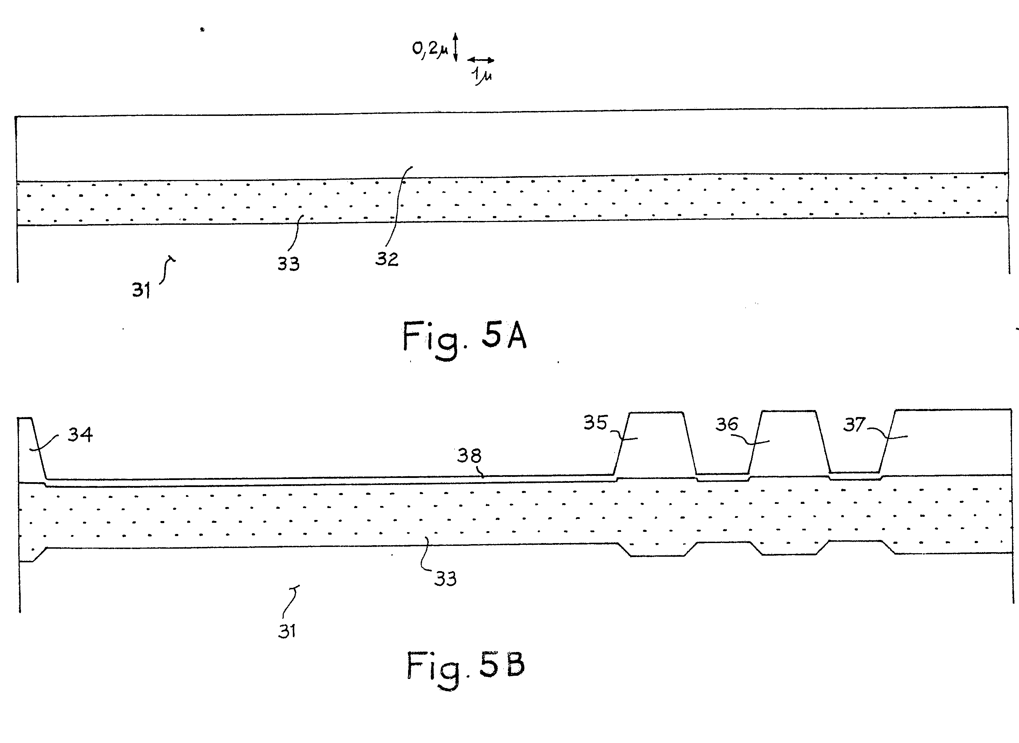

Comme le représente la figure 5A, un aspect essentiel de la présente invention consiste à développer sur un sustrat de silicium 31 de type P une couche de silice thermique 32, cette couche ayant dans l'exemple représenté une épaiseur de l'ordre de 0,5 micron. Ensuite seulement, on procède à une implantation d'un dopant de type P, par exemple du bore, pour former une région surdopée 33 à la surface du substrat de silicium. Cette implantation peut être effectuée par exemple avec une énergie de 180 à 200 keV et avec une dose de l'ordre de $10^{12}$ atomes/cm². Comme on le verra ci-après, étant donné que cette implantation de bore est effectuée après la croissance de la couche de silice thermique 32, croissance que correspond à l'étape thermique la plus longue parmi les étapes thermiques successives ayant lieu lors de la fabrication du circuit intégré, on réussit par ce moyen à diminuer fortement l'extension verticale de la zone implantée 33.

La figure 5B montre l'état de la structure après attaque de la couche d'oxyde 32 pour laisser en place des zones d'oxyde de champ 34 à 37, et après formation d'une couche d'oxyde de grille 38 d'une épaiseur de l'orde de quelque centaines d'angströms.

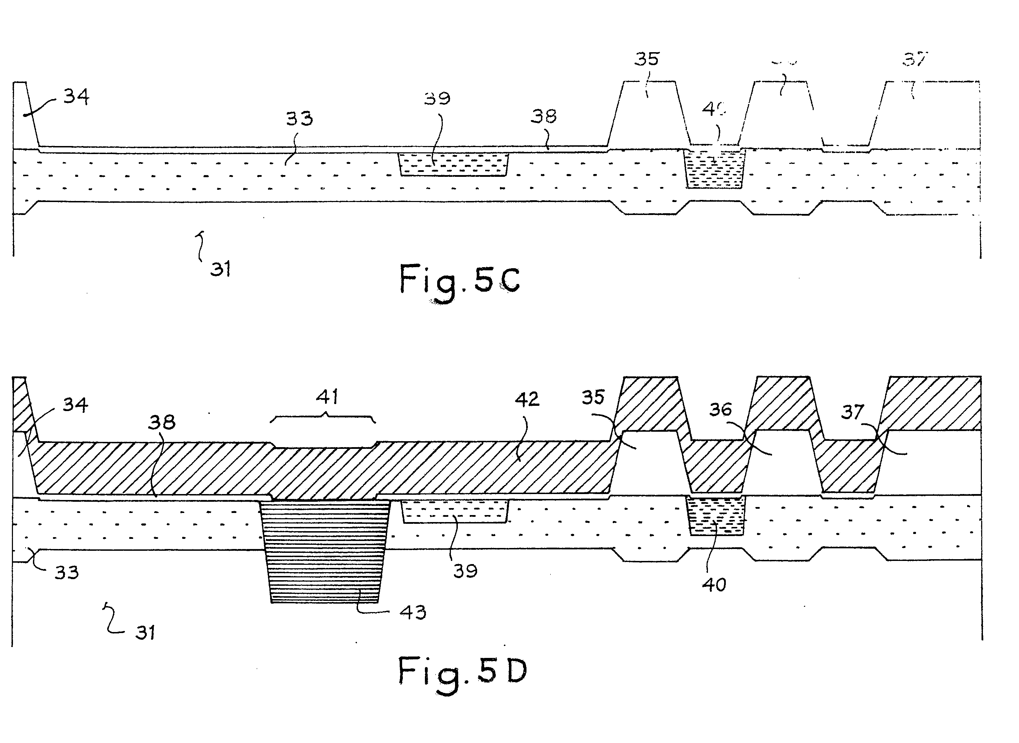

En figure 5C, on a représenté la structure après formation de deux zones de type N: une zone de type N faiblement dopée 39 située à l'intérieur de la région active comprise entre les zones d'oxyde de champ 34 et 35 et une zone de type N fortement dopée 40 située entre les zones d'oxyde de champ 35 et 36.

En figure 5D, on a représenté l'état de la structure après ouverture de la couche d'oxyde de grille 38 dans une zone 41, dépôt d'une couche 42 de silicium polycristallin fortement dopé de type N (in situ ou après dépôt) et diffusion à partir de cette couche de silicium polycristallin à travers l'ouverture 41 d'un puits de type N fortement dopé 43. Si l'on ne cherche pas à réaliser de diffusion à partir de la couche 42, on peut utiliser, au lieu de silicium polycristallin un silicure ou un métal réfractaire.

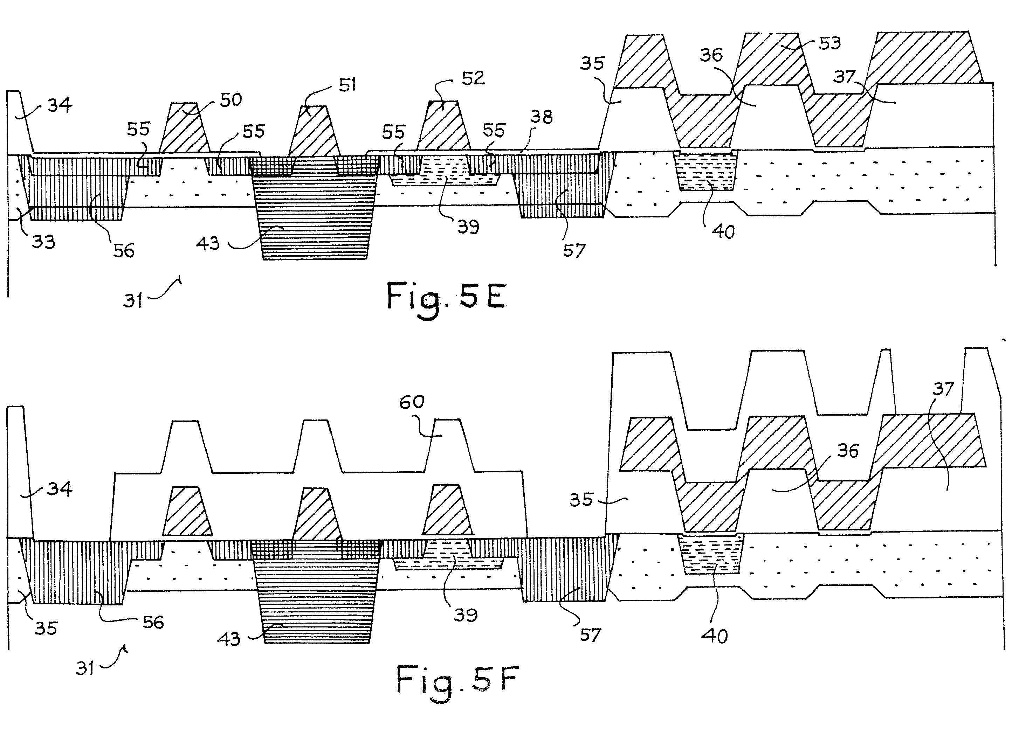

En figure 5E, la couche de silicium polycristallin 42 a été gravée pour laisser en place des zones 50, 51,52 et 53. Une implantation 55 de type N, correspondant notamment à des zones de source et de drain, est réalisée en utilisant comme masque les zones de silicium polycristallin et éventuellement d'oxyde de champ. On réalise ensuite à travers un masque particulier non représenté, des implantations de type N plus fortement dopées et plus profondes 56 et 57 aux emplacements où l'on souhaitera prendre des contacts avec les zones 55.

La figure 5F illustre un état de la structure après que l'on a déposé uniformément une couche isolante 60 ouverte aux emplacements où l'on souhaite affectuer des contacts, cette couche isolante pouvant par exemple être une couche d'oxyde de silicium ou un phosphorsilicate.

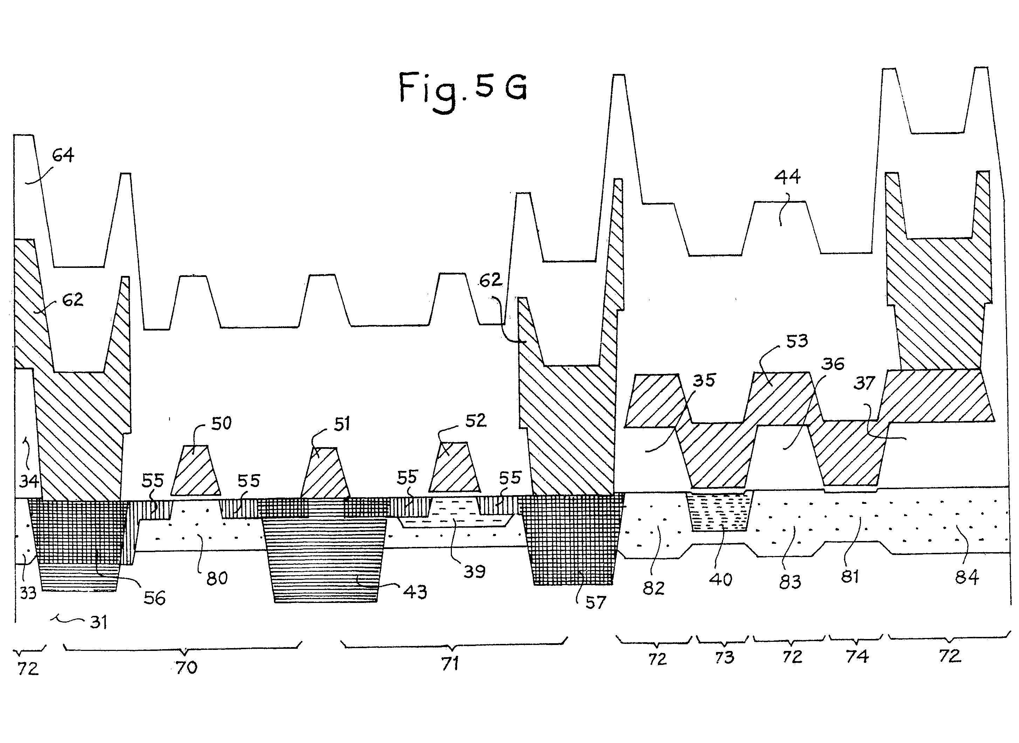

La figure 5G représente l'état final de la structure après que l'on a procédé à un surdopage, par exemple à l'aide de $POCl_3$, des zones ouvertes dans la couche isolante 60, puis à la formation de métallisations 62 et au dépôt final d'une couche de passivation 64, par exemple un phosphosilicate, de l'oxyde de silicium, ou du nitrure de silicium.

Dans la portion de circiut intégré de la figure 5G, on a réalisé un transistor MOS enrichi 70; un transistor MOS déplété 71; des zones de séparation 72 surmontées d'oxyde de champ portant des conducteurs sous lesquels sont placées des zones surdopées d'implantation de champ; une zone de croisement entre connexions 73, la première connexion étant constituée par la couche de silicium polycristallin 53 et la deuxième par la zone monocristalline fortement dopée 40; et un transistor MOS enrichi 74 disposé transversalement par rappot au transistor MOS 70. Les transistors MOS enrichi et déplété 70 et 71 sont connectés dans l'exemple représenté en inverseur, c'est-à-dire que le drain du transistor MOS enrichi 70 est connecté à la source et à la grille du transistor MOS déplété 71, la connexion drain-source étant assurée par la diffuion profonde 43 et la liaison entre cette connexion drain-source et la grille étant réalisée par continuité des zones de silicium polycristallin 51, 52 en dehors du plan de coupe illustré dans la figure.

Alors que la présente invention réside essentiellement dans le mode de réalisation pariculier de la zone implantée 33 par rapport à la couche d'oxyde de champ 32, comme cela est illustré détaillées bien qu'elles correspondent à des modes de réalisation relativement classiques pour mieux faire ressortir les avantages de la présente invention. En effet, en se reportant à la figure 5G, on peut vour que la couche implantée 33 apparaît de façon utile à la surface du sustrat de silicium comme définissant d'une part le dopage (ou implantation de seuil) de la zone intermédiaire entre drain et source pour les transistors MOS enrichis 70 et 74 dans les zones 80 et 81 respectivement et d'autre part le dopage ou implantation de champ sous les zones d'oxyde de champ 35, 36 et 37 dans les emplacements 82, 83 et 84.

C'est là l'un des avantages de la présente invention que, dans le cas de transistors MOS de dimensions extrêmement réduites, ayant des longueurs de canal de l'ordre de 2 microns, le niveau de dopage de la zone intermédiaire entre le drain et la source des transistors MOS enrichis, ou niveau d'implantation de seuil, peut être sensiblement le même que le niveau de dopage sous les zones d'oxyde de champ (implantation de champ) à condition que la profondeur de diffusion soit faible. Comme on peut le voir sur la figure, où l'échelle horizontale est sensiblement cinq fois plus grande que l'échelle verticale, la profondeur de la couche implantée 33 est en fin de processus seulement de l'ordre de 0,2 à 0,3 micron alors que, si cette implantation de champ devait avoir lieu avant la formation de la couche d'oxyde de champ, elle aurait atteint comme cela est classique par suite de l'étape thermique correpondant à l'élaboration de l'oxyde de champ, une épaisseur de l'ordre de quelques microns.

Ainsi, la présente invention atteint les avantages annoncés en obviant aux inconvénients des techniques antérieures. La demanderesse a obtenu ce résultat en imaginant un nouveau procédé inversant l'ordre d'étapes de fabrication dont la succession était bien établie dans la technique antérieure et en rompant avec le préjugé selon lequel les implantations de champ devaient être localisées. Ceci a pu être réalisé grâce au fait que, dans le cas où on vise à réaliser des transistors MOS de dimensions extrêmement réduites, la zone d'oxyde de champ doit avoir une épaisseur réduite de l'ordre de 0,2 à 0,6 micron qui peut être traversée par des ions en provenance d'un implanteur fonctionnant dans les gammes d'énergie classique et que la couche implantée peut être suffisamment peu profonde pour pouvoir être présente au niveau des zones actives.

La présente invention n'est pas limitée aux modes de réalisation qui ont été explicitement décrits. Au contraire, elle en englobe les diverses variantes et généralisations incluses dans le domaine des revendications ci-après.

D'autre part, l'application de l'invention exposée en détail précédemment concerne la fabrication de transistors MOS à canal N sur substrat P, mais on pourra envisager d'autres applications, par exemple des transistors MOS à canal P ou des transistors MOS complémentaires.

## Revendications

1. Procédé de fabrication de circuits intégreés comprenant des transistors à effet de champ de type MOS à la surface d'un substrat de silicium à faible niveau de dopage, caractérisé en ce qu'il comprend les étapes initiales successives suivantes:

a) former une couche d'oxyde thermique d'une épaisseur de l'ordre de 0,2 à 0,6 micron à la surface du substrat,

b) procéder à une implantation ionique uniforme d'un produit dopant dans le silicium à travers toute la surface de la couche d'oxyde pour former une région à la surface du substrat,

c) délimiter ensuite les zones actives en enlevant la couche d'oxyde au dessus de ces zones et en laissant en place les zones d'oxyde de champ.

2. Procédé selon la revendication 1, caractérisé en ce que la couche de silicium est de type P et le dopant implanté également.

3. Procédé selon la revendication 2, caractérise en ce que le dopant implanté est du bore.

4. Procédé selon la revendication 3, caractérisé en ce que l'énergie d'implantation est de l'ordre de 180 à 200 keV et la dose implantée de l'ordre de $10^{12}$ atomes/cm$^2$.

## Patentansprüche

1. Verfahren zur Herstellung integrierter Schaltungen, die MOSFETS an der Oberfläche eines schwach dotierten Siliziumsubstrats enthalten, dadurch gekennzeichnet, daß es die folgenden aufeinanderfolgenden Anfangsschritte aufweist:

a) Bildung einer thermischen Oxidschicht einer Dicke zwischen etwa 0,2 und 0,6 μm an der Substratoberfläche,

b) Dotierung des Siliziums mit einem Dotierprodukt durch gleichmäßige Ionenimplantierung durch die ganze Oberfläche der Oxidschicht hindurch, um eine dotierte Zone an der Oberfläche des Substrats zu bilden,

c) anschließende Begrenzung der aktiven Zonen durch Entfernung der Oxidschicht oberhalb dieser Zonen, wobei zugleich die Feld-Oxid-Zonen erhalten bleiben.

2. Verfahren nach Anspruch 1. dadurch gekennzeichnet, daß die Siliziumschicht ebenso wie das Dotierprodukt vom P-Typ ist.

3. Verfahren nach Anspruch 2. dadurch gekennzeichnet, daß das implantierte Dotierprodukt Bor ist.

4. Verfahren nach Anspruch 3, dadurch gekennzeichnet, daß die Implantierenergie in der Größenordnung von 180 bis 200 keV und die Implantationsdosis in der Größenordnung von $10^{12}$ Atomen pro cm$^2$ liegt.

## Claims

1. A process for manufacturing integrated circuits having MOSFETs at the surface of a silicon substrate having a low doping level, characterized in that it comprises the following successive initial steps:

a) forming a thermal oxide layer of a thickness between about 0,2 and 0,6 μm at the surface of the substrate,

b) effecting a uniform ionic implantation of a doping product in the silicon through the entire surface of the oxide layer in order to create a doped region at the substrate surface,

c) then delimiting the active zones by taking the oxide layer away above these zones and by maintaining in place the field oxide zones.

2. A process according to claim 1, characterized in that the silicon layer as well as the implanted doping product are of the P type.

3. A process according to claim 2, characterized in that the implanted doping product is boron.

4. A process according to claim 3, characterized in that the implantation energy is in the range of about 180 to 200 keV and the implanted dose is about $10^{12}$ atoms/cm$^2$.

Fig.1

Fig.2A

Fig.2B

Fig.3A

Fig.3B

Fig.3C

Fig. 4 A

Fig. 4 B

Fig. 4 C

Fig. 4 D

Fig. 4 E

0 065 464

0,2µ

1µ

31

33    32

## Fig. 5A

34

35    36    37

38

33

31

## Fig. 5B

0 065 464

Fig.5C

Fig.5D

Fig. 5E

Fig. 5F

Fig. 5 G

0 065 464